# EUROPEAN PATENT SPECIFICATION

(11) **EP 2 987 876 B1**
(45) Date of publication and mention of the grant of the patent: **03.10.2018**
(21) Application number: 13882069.1
(22) Date of filing: 18.04.2013
(51) Int. Cl.: C22C 13/02, B23K 1/00, B23K 1/19, B23K 35/26, C22C 12/00, H01L 21/60, H05K 3/34, H01L 23/00

(54) **LEAD-FREE SOLDER ALLOY**
BLEIFREIE MESSINGLEGIERUNG
ALLIAGE DE SOUDAGE SANS PLOMB

(43) Date of publication of application: 24.02.2016
(73) Proprietor: Senju Metal Industry Co., Ltd, Tokyo 120-8555 (JP)
(72) Inventor: TACHIBANA Ken, Tokyo 120-8555 (JP); NOMURA Hikaru, Tokyo 120-8555 (JP)
(74) Representative: D Young & Co LLP
(86) International application number: PCT/JP2013/061531
(87) International publication number: WO 2014/170994

(56) References cited:
- WO-A1-2006/131979
- WO-A1-2007/125861
- CN-B- 101 392 337
- JP-A- H1 076 389
- JP-A- 2004 154 864
- JP-A- 2010 000 537
- JP-A- 2013 000 744
- US-A- 6 156 132
- US-A1- 2008 061 117
- US-B2- 6 984 254
- US-B2- 7 132 020
- B.L. YOUNG, J. G. DUH: "Interfacial reaction and microstructural evolution for electroplated Ni and electroless Ni in the under bump metallurgy with 48Sn58Bi solder during annealing", JOURNAL OF ELECTRONIC MATERIALS, vol. 30, no. 7, 1 July 2001 (2001-07-01), pages 878-884, XP002765335,
- C.S. HUANG, J.H. YEH, B.L. YOUNG, J.G. DUH: "Phenomena of electroless Ni-P and intermetallic-compound stripping and dissolving in Sn-Bi and Sn-Pb solder joints with Au/EN/Cu metallization", JOURNAL OF ELECTRONIC MATERIALS, vol. 31, no. 11, 1 November 2002 (2002-11-01), pages 1230-1237, XP002765336,
- JIANFENG LI ET AL.: 'Interfacial Reaction Between Molten Sn-Bi Based Solders and Electroless Ni-P Coatings for Liquid Solder Interconnects' IEEE TRANSACTIONS ON COMPONENTS AND PACKAGING TECHNOLOGIES vol. 31, pages 574 - 585, XP011346857

## Description

### [TECHNICAL FIELD]

The present invention relates to a lead-free solder alloy. It particularly relates to a Sn-Bi-Cu-Ni series solder alloy that is superior in joining reliability.

### [BACKGROUND]

In recent years, an electronic apparatus such as cellular phone has a trend toward its miniaturization and/or thinning. A thin substrate having a thickness from about some mm to 1 mm or less has been often used in electronic parts such as semiconductor device employed in such an electronic apparatus.

On the other hand, in the past, a Sn-Ag-Cu solder alloy has been widely used as lead-free solder. The Sn-Ag-Cu solder alloy has a relatively high melting point and even a Sn-3Ag-0.5Cu solder alloy having a eutectic composition shows a melting point of about 220 degrees C. For this reason, when performing the soldering on electrodes of the above-mentioned thin substrate with the Sn-Ag-Cu solder alloy, the substrate may become strained by heat when joining them so that any joining failure may occur.

To avert such joining failure, it has been often conducted to perform the soldering at low temperature to suppress any strain in the thin substrate, thereby enhancing the joining reliability. A Sn-Bi solder alloy is known as the solder alloy having the low melting point, which can correspond to this. Among these solder alloys, a Sn-58Bi solder alloy has a very low melting point of about 140 degrees C and can suppress the strain in the substrate.

However, Bi is naturally a brittle element and the Sn-Bi solder alloy is also brittle. Even when Bi content of the Si-Bi solder alloy is decreased, it becomes brittle because Bi segregates in Sn. A solder joint soldered by using the Sn-Bi solder alloy may generate any cracks because of its brittleness when any considerable stress is added thereto so that its mechanical strength may deteriorate.

Further, in order to cope with the miniaturization of the electronic parts, an area of the substrate which is used therefor must be narrower and a miniaturization of the electrode and/or a narrow pitch between the electrodes must be realized. Additionally, because an amount of the solder alloy used when performing the soldering is decreased, the mechanical strength of the solder joint deteriorates.

So, Patent Document 1 discloses Sn-Bi-Cu-Ni lead-free solder alloy in which Cu and Ni are added to the Sn-Bi solder alloy in order to realize any solder joined portion that has a high joining strength. According to this document, this joined portion using this solder alloy improves its mechanical strength because any intermetallic compounds having hexagonal closest packing structure are formed in the solder joined portion and/or on a solder joining interface.

### [DOCUMENT FOR PRIOR ART]

### [PATENT DOCUMENT]

Patent Document 1: Japanese Patent Application Publication No.2013-00744.

### [SUMMARY OF THE INVENTION]

### [PROBLEMS TO BE SOLVED BY THE INVENTION]

The electrode of the electronic parts is normally made of Cu and this Cu electrode is generally coated by no-electrode Ni plating, electroless Ni/Au plating or electroless Ni/Pd/Au plating. Thus, the electroless plating with noble metal such as Au and a combination of Au and Pd is performed on the Cu electrode. The Au plating suppresses oxidization of undercoated Ni plating and improves wettability to the molten solder. The electroless Ni plating forms Ni plating containing a considerable amount of P derived from a reducing agent (for example, sodium hypophosphite) which is used in the electroless plating. Such Ni plating contains at least some mass percent, for example, 2 through 15 mass% of P.

However, although Patent Document 1 discloses that Cu and Ni are added to the Sn-Bi solder alloy to form the intermetallic compounds having hexagonal closest packing structure on the joining interface between the solder alloy and a Cu wiring part derived from the electrode, it does not disclose any alloy components specifically nor disclose any results for establishing an effect of high joining strength. Although the same document discloses a range of contents of Cu and Ni to be added to a component in which Sn is of 57 atm % and Bi is of 43 atm %, it is unknown to improve the joining strength within all this range.

Further, although the same document discloses Cu wiring parts of the printing circuit board and wiring parts each containing no Cu as an object to be joined with the solder alloy, it is unknown what kind of configuration the object to be joined has except that the wiring parts are made of Cu. Since the same document does not disclose any alloy components of the solder alloy specifically as stated above, it does not disclose nor support any condition of the joining interface except that the metallic compounds are formed on the joining interface between the electrode and the solder alloy. Therefore, when all the solder alloys which meet contents of Bi, Cu and Ni disclosed in the same document are used for soldering the Cu electrode on which, for example, the electroless Ni plating has been performed, it is hard to think that the following problems can be solved thereby.

When performing the soldering on the Cu electrode on which the electroless Ni plating has been performed, Ni is preferentially diffused to the solder alloy because Ni in the solder alloy has larger diffusion coefficient than that of P. A portion which is relatively higher in concentration of P is generated on the joining interface between the solder alloy and the electrode, so that a so-called P-rich layer is formed. Since this P-rich layer is solid and brittle, it causes shear strength of the solder joint to deteriorate. When shearing the solder joint having such a P-rich layer by a shearing, a phenomenon is generated such that any Ni plating layer is exposed. This shearing is caused by peeling off the P-rich layer formed on the electrode rather than shearing the solder joint itself. Therefore, the formation of P-rich layer exerts a bad influence upon joining reliability of the solder joint.

Similarly, when performing the soldering on the Cu electrode on which any plating has not performed, it is not certain whether or not all the solder alloys meeting regions of contents of the elements disclosed in the same document indicate high joining strength. Patent Document US 6,156,132 describes a Pb free solder, consisting of Bi and balance Sn. Claim 5 of D1 discloses a solder alloy that consists of 0-58% Bi, 0<Ni≤0.2, 0<Cu≤1, and at least one of 0<Ge≤0.1, 0<Ag≤5, 0<Sb≤5, balance Sn.

Here, it is a problem of the present invention to provide a Sn-Bi-Cu-Ni series lead-free solder alloy which has a low melting point, good ductility and high tensile strength, suppresses thermal strain in the substrate by high shear strength indicated by the solder joint formed when performing the soldering on the Cu electrode on which the electroless Ni plating has been performed, and is superior in joining reliability. In addition, it is a problem of the present invention to provide a Sn-Bi-Cu-Ni series lead-free solder alloy which is superior in joining reliability even for the Cu electrode on which any plating has been not performed by high shear strength indicated by the solder joint formed by the soldering.

### [MEANS FOR SOLVING THE PROBLEMS]

Inventors have focused on that in order to enhance shear strength when performing the soldering on an electrode having Ni plating layer containing P, which is formed by the electroless Ni plating, Ni in the solder alloy has larger diffusion coefficient than that of P. The inventors then have come to realize that it is possible to suppress growth of the P-rich layer by suppressing diffusion of Ni into the solder alloy when performing the soldering and they have eagerly studied to enhance the shear strength.

First, the inventors have performed the soldering on the electrode having the electroless Ni plating layer by adding merely about 0.5 mass% of Cu to the Sn-Bi solder alloy so that they have found that the solder joint formed by the soldering is inferior in the shear strength. Accordingly, they have also found that even when the content of Cu is increased up to 1.1 mass% in this Sn-Bi-Cu solder alloy, the shear strength thereof is not enhanced, the melting point thereof becomes higher and ductility thereof considerably deteriorates. Namely, the inventors have found that even when merely Cu is added to the Sn-Bi solder, it is impossible to enhance the shear strength in the formed solder joint and the contents of Cu may cause such a program that the melting point thereof becomes higher and ductility thereof becomes low.

Based on the above finding by adding merely Cu thereto, the inventors have focused on the content of Cu to be added to the Sn-Bi solder alloy and Ni which is complete solid solubility with Cu and they have finely searched the contents of Ni. As a result thereof, the inventors have found that when it contains 0.3 through 1.0 mass% of Cu and 0.01 through 0.06 mass% of Ni, it has a low melting point, good ductility and high tensile strength and suppresses growth of P-rich layer as well as the shear strength is considerably improved in the solder joint formed on the Cu electrode having the electroless Ni plating layer. Accordingly, the inventors have found that it is possible to reduce any strain in the substrate when performing the soldering based on the thinning of the substrate so that an excellent joining reliability can be given. Further, the inventors have performed the soldering on the Cu electrode on which any electroless Ni plating has been not performed in order to check its multiplicity of uses, so that they have found that the solder joint formed on such a Cu electrode also indicates high shear strength, similar to the solder joint formed on the Cu electrode having the electroless Ni plating layer, thereby completing the invention.

Here, the present invention is as follows:
(1) A lead-free solder alloy having an alloy composition which substantially consists of 31 to 59 mass % of Bi, 0.3 to 1.0 mass % of Cu, 0.01 to 0.06 mass % of Ni, optionally at least one element selected from the group consisting of P and Ge in a total of 0.002 to 0.1 mass %, and at least one element selected from the group consisting of 0.001 to 0.07 mass% P and 0.001 to 0.03 mass% Ge, and a balance of Sn wherein the solder alloy has a melting point of 185 degrees C or less, a tensile strength of 70 MPa or more and elongation of 65 % or more.
(2) The lead-free solder alloy described in the above-mentioned item (1), substantially consists of 31 to 59 mass % of Bi, 0.3 to 1.0 mass % of Cu, 0.01 to 0.06 mass % of Ni, and at least one element selected from the group consisting of P and Ge in a total of 0.003 to 0.05 mass %, and a balance of Sn.
(3) A solder joint formed on a Cu electrode having a Ni plating layer by using the lead-free solder alloy described in the above-mentioned item (1) or (2),
4. The solder joint according to claim 3 wherein further comprising a P-rich layer formed at an interface between the lead-free solder alloy and the Ni plating layer
(5) A substrate having a thickness of 5 mm or less and plural Cu electrodes each having Ni plating layer wherein each of the Cu electrodes includes a solder joint formed by the lead-free solder alloy described in the above-mentioned item (1) or (2),
6. The substrate according to Claimclaim 5 wherein the Ni plating layer contains P.

The lead-free solder alloy according to the invention is applicable to a use of the soldering on the Cu electrode formed on a thin substrate having a thickness of 5 mm or less, on which electroless Ni plating is performed. The effect of the invention is best exhibited by reliability of the solder joint is improved because growth of P-rich layer on the joining interface, which causes shear strength of the solder joint to deteriorate, is suppressed and the solder alloy has good ductility (elongation) and high tensile strength. Further, the lead-free solder alloy according to the invention is also applicable to a use of the soldering on Cu electrode on which any electroless Ni plating has been not performed.

### [BRIEF DESCRIPTION OF DRAWINGS]

[FIG.1] FIG. 1 is a photograph of 300 magnifications showing a surface of a Cu electrode on which electroless Ni/Au plating has been performed after the Cu electrode is soldered using Sn-58Bi solder alloy and the solder joined portion is sheared and removed.
[FIG.2] FIGS. 2(a) and 2(b) are sectional photographs each showing a neighborhood of an interface between the solder joined portion and the Cu electrode on which electroless Ni/Au plating has been performed, each of 800 magnifications, when a solder joint is formed by soldering the Cu electrode; and FIGS. 2(c) and 2(d) are sectional photographs each showing a neighborhood of an interface between the solder joined portion and the Cu electrode on which electroless Ni/Pd/Au plating has been performed, each of 800 magnifications, when a solder joint is formed by soldering the Cu electrode.
[FIG.3] FIG. 3 is a graph showing a relationship between Cu content and shear strength (Cu electrode) in Sn-40Bi-(0-1.1)Cu-0.03Ni solder alloy.
[FIG.4] FIG.4 is a graph showing a relationship between Cu content and shear strength (electroless Ni/Au electrode) in Sn-40Bi-(0-1.1)Cu-0.03Ni solder alloy.
[FIG.5] FIG. 5 is a graph showing a relationship between Cu content and elongation of the alloy in Sn-40Bi-(0-1.1)Cu-0.03Ni solder alloy.
[FIG.6] FIG. 6 is a graph showing a relationship between Cu content and shear strength (Cu electrode) in Sn-40Bi-0.5Cu-(0-0.07)Ni solder alloy.
[FIG. 7] FIG. 7 is a graph showing a relationship between Cu content and shear strength (electroless Ni/Au electrode) in Sn-40Bi-0.5Cu-(0-0.07)Ni solder alloy.
[FIG. 8] FIG. 8 is a graph showing a relationship between Cu content and elongation of the alloy in Sn-40Bi-0.5Cu-(0-0.07)Ni solder alloy.

### [EMBODIMENT FOR CARRYING OUT THE INVENTION]

The following will describe the invention more in detail. In this specification, the term, % relating to the solder alloy compositions indicates to mass% unless otherwise noted.

The lead-free solder alloy according to the invention is a Sn-Bi-Cu-Ni solder alloy containing Cu and Ni. Since Cu and Ni are complete solid solubility, in the lead-free solder alloy according to the invention previously containing Cu and Ni, the solubility of Cu and Ni is reduced so that it is possible to suppress diffusion of Cu and Ni from the electrode to the solder alloy. The suppression of the diffusion of Ni may suppress growth of P-rich layer formed on the electroless Ni plating layer. Here, it seems that it is also possible to suppress the diffusion of Cu and Ni by adding only Cu to a Sn-Bi solder alloy to increase content of Cu.

Since, however, even if the content of Cu is merely increased in a Sn-Bi-Cu solder alloy, Cu Sn compound is also increased in the joining interface with the electrode and in the solder alloy, the shear strength thereof deteriorates, a melting point of the solder alloy itself becomes higher and the ductility thereof is reduced. Therefore, the Sn-Bi-Cu solder alloy is not usable for the soldering on the Cu electrode having any electroless Ni plating layer.

Here, Ni is listed as an element for reducing solubility of Ni without increasing content of Cu. When the solder alloy contains a small amount of Ni, the solder alloy indicates a low melting point and high ductility. When electroless Ni plating such as electroless Ni/Au plating or electroless Ni/Pd/Au plating is performed on the electrode, the shear strength of the solder joint is considerably improved by suppressing the diffusion of Ni to the solder alloy and suppressing growth of the brittle P-rich layer.

Further, the lead-free solder alloy according to the invention has a low solubility of Cu because it contains predetermined amounts of Cu and Ni. For the Cu electrode having no electroless Ni plating layer, it is possible to suppress the diffusion of Cu to the solder alloy and to suppress excess formation of brittle Sn Cu compound formed in the joining interface and the solder alloy so that the shear strength of the solder joint is enhanced. As a result thereof, in this invention, it is possible to suppress any strain in the thin substrate when performing the soldering regardless of whether or not plating is performed on the Cu electrode, and to maintain the good joining reliability.

As described before, the plating layer of noble metal such as Au and Au/Pd or its alloy is normally formed on the electroless Ni plating layer. The Au plating layer is formed on the Ni plating layer. The Au plating player, however, has a very thin thickness of about 0.05 µm and is diffused into the solder alloy to disappear when performing the soldering. Therefore, when assessing various kinds of characteristics in this invention, it is not necessary to particularly take into consideration the Au plating layer and other noble metal plating layer.

In this invention, the reason why the components of the solder alloy are limited is as follows:
The content of Bi is of 31 % through 59 %. Bi reduces the melting point of the solder alloy. When the content of Bi is less than 31 %, the melting point thereof is high, so that the substrate is strained when performing the soldering. When the content of Bi is more than 59 %, tensile strength and ductility thereof deteriorates because of precipitation of Bi. The content of Bi is preferably of 31 % through 59 %, more preferably, 35 % through 58 %.

Moreover, it contains at least one element selected from the group consisting of 0.001 to 0.07 mass% P and 0.001 to 0.03 mass% Ge, and a
The content of Cu is of 0.3 % through 1.0 %. Cu suppresses the diffusion of Ni in the electroless Ni plating layer to the solder alloy and suppresses the growth of P-rich layer generated on an interface between the Ni plating layer and the solder joined portion. Further, since it suppresses the diffusion of Cu, it suppresses excess formation of the brittle Sn Cu compound formed in the joining interface between the Cu electrode on which the electroless Ni plating is not performed and the solder joined portion and in the solder alloy so that the shear strength of the solder joint is enhanced. When the content of Cu is less than 0.3 %, it is impossible to suppress the P-rich layer or excess formation of the Sn Cu compound so that the shear strength thereof is reduced. When the content of Cu is more than 1.0 %, an intermetallic compound with Sn is excessively formed in the solder alloy so that ductility of the solder alloy is reduced. Further, the melting point of the solder alloy becomes very high so that wettability of the solder alloy is reduced. Additionally, any strain occurs in the substrate so that workability thereof deteriorates. The content of Cu is preferably of 0.3 % through 0.8 %, more preferably, 0.3% through 0.7 %.

The content of Ni is of 0.01 % through 0.06 %. Addition of Ni helps any effect of Cu for suppressing the diffusion of Ni, and expresses an effect of suppressing the growth of P-rich layer to further improve the shear strength. When the content of Ni is less than 0.01 %, it is impossible to exhibit the effect of improving the shear strength. When content of Ni is more than 0.06 %, Sn and Ni compound is excessively formed in the solder alloy so that the ductility thereof is reduced. The content of Ni is preferably of 0.02 % through 0.05 %.

The lead-free solder alloy according to the invention has to contain at least one of elements selected from a group consisting of P and Ge, preferably in a total of 0.003 % through 0.05 %. Addition of these elements suppresses the growth of P-rich layer to enhance the shear strength of the solder joint, similarly in a case where they are not added, and exhibits an effect to prevent the solder alloy from being discolored to yellow or the like (hereinafter, as referred to "yellow" appropriately) because of its oxidization. The lead-free solder alloy according to the invention can be used in a form of solder ball. The solder balls are mounted on a module substrate and installed on the electrodes by reflow. It is then determined whether or not the soldering is performed using any image recognition. When the solder ball is yellowed by oxygen which is inevitably mixed into a reflow atmosphere by heating at the reflow, the yellowed solder ball is determined to be defect because the image recognition cannot recognize such a ball. Therefore, the solder ball is advantageous to be not yellowed during the reflow. The lead-free solder alloy according to the invention can avoid any errors in a bump quality inspection by containing at least one of elements selected from a group consisting of P and Ge and preventing it from being discolored by oxygen or the like.

From these viewpoints, it contains at least one element selected from the group consisting of 0.001 to 0.07 mass% P and 0.001 to 0.03 mass% Ge.

The lead-free solder alloy according to the invention having these alloy components does not expose any electroless Ni plating layer of the electrode when the solder joined portion of the solder joint is sheared and removed. This is because, as described before, the lead-free solder alloy according to the invention can suppress the diffusion of Ni in the electroless Ni plating layer and suppress the growth of P-rich layer formed on a surface of the plating layer. As a result thereof, in the lead-free solder alloy according to the invention, a mechanical characteristic, particularly shear strength of the interface of joined portion is considerably improved.

Further, the lead-free solder alloy according to the invention can be used in a form of preform, wire, solder paste, solder ball or the like. The lead-free solder alloy according to the invention has high tensile strength and ductility and high shear strength. Accordingly, in a case where it is used in a form of solder ball, it is possible to miniaturize the solder ball so that it is less than the conventional solder ball, which can sufficiently correspond to the thinning of the substrate and the miniaturization of electrode, which are used in the electronic parts or the like.

The lead-free solder alloy according to the invention can form the solder joint by joining electrodes of package (PKG) such as IC chip to electrodes of the substrate such as printed circuit board (PCB). Here, the lead-free solder alloy according to the invention maintains high ductility and tensile strength as well as has excellent shear strength when it is applied to the solder joint, as described above. Thus, the electrodes and the solder joined portions do not rupture to each other even when a strain slightly occurs in the substrate at the reflow so that it is possible to maintain the good joining reliability even when the substrate which is thinner than that of the conventional substrate is used. The solder joint according to this invention includes an electrode and the solder joined portion. The solder joined portion is referred to as "a portion which is formed principally by the solder alloy".

The substrate according to the invention has a thickness of 5 mm or less and a plurality of Cu electrodes each having Ni plating layer. Each Cu electrode has the solder joint formed by using the lead-free solder alloy according to the invention. Since in the substrate according to the invention, the joint is formed using the lead-free solder alloy according to the invention having a low melting point and good ductility, even when the substrate has a thickness of 5 mm or less, it suppresses occurrence of the curvature thereof and has an excellent joining reliability. The thickness of the substrate is preferably 3 mm or less, more preferably, 2 mm or less. As material of the substrate, Si, glass epoxy, paper phenol, Bakelite and the like are listed. As the electrodes which the substrate has, the Cu electrodes on which any plating is not performed, the Cu electrodes on which any Ni plating or the like is performed, Ni electrodes are listed.

By using high purity material or low α ray material in the lead-free solder alloy according to the invention, it is possible to manufacture low α ray lead-free solder alloy. When this solder alloy is used around a memory, it is possible to prevent any soft errors from occurring.

### [Embodiments]

The solder alloys shown in Table 1 were manufactured. Using these solder alloys, the melting points of the solder alloys, tensile strength thereof, elongation (ductility) thereof were measured. Using the solder joint formed by using these solder alloys, thickness measurement of P-rich layer, shear strength and exposure percentage of plate exposure percentage were obtained as follows. The result thereof is shown in the Table 1.

### (Melting Points of Solder Alloys)

The melting points were measured at degrees C under a condition of temperature rising speed of 5 degrees C/min using Differential Scanning Calorimetry (DSC6200) by SEIKO Instrument Inc. were measured at degrees C.

### (Tensile Strength and Elongation (Ductility))

The solder alloys shown in Table 1 were formed so as to be a predetermined form. Their tensile strength (MPa) and elongation (%) were measured under a condition of stroke speed of 6.0 mm/min and strain speed of 0.33 %/sec using a tensile strength test machine (AUTO GRAPH AG-20kN by Shimazu Corporation). When it has the tensile strength of 70 MPa or more and the elongation of 65% or more, it can be used with having no problem in practical use.

### (Thickness of P-rich Layer)

The soldering was performed so that the solder alloys shown in Table 1 were joined to Cu electrodes on PCB having a thickness of the substrate of 1.2 mm, on which the electro less Ni/Au plating had been performed (hereinafter, this Cu electrodes are referred to as "electroless Ni/Au electrodes"), each electrode having a diameter of 0.24 mm. The soldering was performed so that by using aqueous flux (WF-6400 made by SENJU METAL INDUSTRY CO., LTD), solder balls each having a diameter of 0.3 mm, which were manufactured by the solder alloys, were mounted on the substrate after the aqueous flux was applied thereto and they were soldered by reflow method under a reflow profile in which the peak temperature is set to be 210 degrees C. Thus, samples on which the solder joints were formed were obtained.

The thickness of P-rich layer of each sample was determined on the basis of SEM photograph by inspecting a section of a neighborhood of an interface between the solder joined portion and the Ni plating layer. Specifically, photographs were analyzed using an electron microscope (JSM-7000F manufactured by Japan Electron Optics Laboratory), the P-rich layer and non P-rich layer were separated from each other by sorting them according to colors, and the thickness of the P-rich layer was measured at (µm). On 5 samples manufactured under the same condition, thicknesses of their P-rich layer were similarly measured and an average value thereof was determined to be the thickness of the P-rich layer.

### (Shear Strength)

Regarding the electrodes on the above-mentioned PCB, two species of electrodes such as Cu electrodes on which any plating was not performed (hereinafter, merely referred to as "Cu electrodes") and the electroless Ni/Au electrodes were used and the soldering was performed so that they were joined to the solder alloys shown in Table 1. Shear strength of each of these samples was measured at (N) by a shear strength measurement apparatus (SERIES 4000HS manufactured by DAGE Corporation) under a condition of 1000 mm/sec. When the shear strength is 3.00N or more on the Cu electrodes and the shear strength is 2.60 N or more on the electroless Ni/Au electrodes, it can be used with having no problem in practical use.

### (Plate Exposure Percentage)

The SEM photographs were photographed on a surface of each of the electroless Ni/Au electrodes of the shear strength tested samples after the solder joined portion was sheared and removed. A region from which Ni was exposed was identified by performing EDS analysis and by using image analysis software (Scandium) made by Seika Corporation, an area of the region was obtained. Finally, the plate exposure percentage (%) was calculated by dividing the area of the region from which Ni plating layer was exposed by whole area of electrode.

**[Table 1]**

| | COMPOSITION (MASS%) | | | | | | MELTING POINT (°C) | TENSILE STRENGTH (MPa) | ELONGATION (%) | THICKNESS OF P-RICH LAYER (*µ*m) | SHEAR STRENGTH (N) | | PLATE EXPOSURE PERCENTAGE (%) |
|---|---|---|---|---|---|---|---|---|---|---|---|---|---|
| | Sn | Bi | Cu | Ni | P | Ge | | | | | Cu ELETRODE | ELECTROLESS Ni/Au ELECTRODE | ELECTROLESS Ni/Au ELECTRODE |
| EMBODIMENT 1 | bal. | 35 | 0.3 | 0.03 | 0 | 0 | 183.1 | 79.9 | 78.2 | 0.011 | 3.21 | 2.85 | 0 |
| EMBODIMENT 2 | bal. | 35 | 0.5 | 0.03 | 0 | 0 | 183.8 | 80.2 | 78.0 | 0.010 | 3.38 | 2.78 | 0 |
| EMBODIMENT 3 | bal. | 35 | 0.7 | 0.03 | 0 | 0 | 183.2 | 81.3 | 76.1 | 0.010 | 3.49 | 2.89 | 0 |
| EMBODIMENT 4 | bal. | 35 | 0.5 | 0.01 | 0 | 0 | 183.7 | 79.3 | 77.2 | 0.013 | 3.14 | 2.77 | 0 |
| EMBODIMENT 5 | bal. | 35 | 0.5 | 0.06 | 0 | 0 | 183.9 | 80.4 | 76.5 | 0.012 | 3.38 | 2.87 | 0 |
| EMBODIMENT 6 | bal. | 40 | 0.3 | 0.03 | 0 | 0 | 173.9 | 77.9 | 87.3 | 0.012 | 3.29 | 2.75 | 0 |
| EMBODIMENT 7 | bal. | 40 | 0.5 | 0.03 | 0 | 0 | 173.5 | 78.2 | 87.1 | 0.010 | 3.18 | 2.85 | 0 |
| EMBODIMENT 8 | bal. | 40 | 0.7 | 0.03 | 0 | 0 | 173.8 | 78.3 | 86.4 | 0.010 | 3.22 | 2.67 | 0 |
| EMBODIMENT 9 | bal. | 40 | 0.9 | 0.03 | 0 | 0 | 174.3 | 77.6 | 84.1 | 0.013 | 3.21 | 2.62 | 0 |
| EMBODIMENT 10 | bal. | 40 | 0.5 | 0.01 | 0 | 0 | 173.5 | 79.3 | 88.3 | 0.013 | 3.19 | 2.74 | 0 |
| EMBODIMENT 11 | bal. | 40 | 0.5 | 0.06 | 0 | 0 | 174.1 | 78.9 | 89.4 | 0.012 | 3.32 | 2.77 | 0 |
| EMBODIMENT 12 | bal. | 45 | 0.3 | 0.03 | 0 | 0 | 165.7 | 77.4 | 75.3 | 0.009 | 3.28 | 2.81 | 0 |
| EMBODIMENT 13 | bal. | 45 | 0.5 | 0.03 | 0 | 0 | 165.2 | 78.1 | 75.1 | 0.014 | 3.31 | 2.86 | 0 |
| EMBODIMENT 14 | bal. | 45 | 0.7 | 0.03 | 0 | 0 | 165.0 | 78.5 | 76.6 | 0.012 | 3.38 | 2.79 | 0 |
| EMBODIMENT 15 | bal. | 45 | 0.5 | 0.01 | 0 | 0 | 165.3 | 77.9 | 75.6 | 0.010 | 3.23 | 2.78 | 0 |
| EMBODIMENT 16 | bal. | 45 | 0.5 | 0.06 | 0 | 0 | 165.7 | 78.8 | 75.0 | 0.013 | 3.34 | 2.71 | 0 |
| EMBODIMENT 17 | bal. | 58 | 0.3 | 0.03 | 0 | 0 | 139.8 | 74.6 | 68.5 | 0.012 | 3.21 | 2.76 | 0 |
| EMBODIMENT 18 | bal. | 58 | 0.5 | 0.03 | 0 | 0 | 1402 | 75.8 | 67.3 | 0.008 | 3.24 | 2.75 | 0 |
| EMBODIMENT 19 | bal. | 58 | 0.7 | 0.03 | 0 | 0 | 139.7 | 74.9 | 67.2 | 0.014 | 3.39 | 2.75 | 0 |
| EMBODIMENT 20 | bal. | 58 | 0.5 | 0.01 | 0 | 0 | 140.0 | 75.3 | 68.1 | 0.012 | 3.16 | 2.78 | 0 |
| EMBODIMENT 21 | bal. | 58 | 0.5 | 0.06 | 0 | 0 | 139.9 | 75.9 | 66.9 | 0.010 | 3.26 | 2.69 | 0 |
| EMBODIMENT 22 | bal. | 35 | 0.5 | 0.01 | 0.003 | 0 | 184.0 | 78.9 | 77.4 | 0.011 | 3.21 | 2.72 | 0 |
| EMBODIMENT 23 | bal. | 35 | 0.5 | 0.06 | 0.05 | 0 | 184.5 | 78.3 | 75.3 | 0.013 | 3.12 | 2.89 | 0 |
| EMBODIMENT 24 | bal. | 40 | 0.5 | 0.01 | 0.003 | 0 | 173.4 | 78.3 | 89.2 | 0.012 | 3.21 | 2.79 | 0 |
| EMBODIMENT 25 | bal. | 40 | 0.5 | 0.06 | 0.05 | 0 | 173.7 | 79.1 | 86.9 | 0.013 | 3.33 | 2.74 | 0 |
| EMBODIMENT 26 | bal. | 45 | 0.5 | 0.01 | 0.003 | 0 | 165.1 | 77.6 | 77.1 | 0.011 | 3.28 | 2.71 | 0 |
| EMBODIMENT 27 | bal. | 45 | 0.5 | 0.06 | 0.05 | 0 | 165.7 | 77.3 | 74.3 | 0.014 | 3.38 | 2.85 | 0 |
| EMBODIMENT 28 | bal. | 58 | 0.5 | 0.01 | 0.003 | 0 | 139.6 | 75.1 | 68.1 | 0.012 | 3.15 | 2.73 | 0 |
| EMBODIMENT 29 | bal. | 58 | 0.5 | 0.06 | 0.05 | 0 | 140.3 | 75.9 | 66.3 | 0.013 | 3.31 | 2.72 | 0 |
| EMBODIMENT 30 | bal. | 35 | 0.5 | 0.01 | 0 | 0.003 | 184.1 | 78.5 | 78.1 | 0.011 | 3.15 | 2.78 | 0 |
| EMBODIMENT 31 | bal. | 58 | 0.5 | 0.06 | 0 | 0.05 | 140.4 | 77.9 | 65.8 | 0.012 | 3.28 | 2.81 | 0 |
| EMBODIMENT 32 | bal. | 35 | 0.5 | 0.01 | 0.0015 | 0.0015 | 183.9 | 78.3 | 76.9 | 0.012 | 3.17 | 2.77 | 0 |
| EMBODIMENT 33 | bal. | 58 | 0.5 | 0.06 | 0.025 | 0.025 | 140.1 | 76.9 | 66.4 | 0.012 | 3.19 | 2.75 | 0 |
| COMPARISON EXAMPLE 1 | bal. | 58 | 0 | 0 | 0 | 0 | 140.0 | 69.7 | 65.8 | 0.092 | 2.30 | 2.01 | 59 |
| COMPARISON EXAMPLE 2 | bal. | 40 | 0.5 | 0 | 0 | 0 | 173.4 | 76.1 | 80.9 | 0.016 | 2.61 | 2.43 | 0 |
| COMPARISON EXAMPLE 3 | bal. | 40 | 0 | 0.03 | 0 | 0 | 174.4 | 75.3 | 81.7 | 0.046 | 2.63 | 2.26 | 49 |
| COMPARISON EXAMPLE 4 | bal. | 30 | 0.5 | 0.03 | 0 | 0 | 187.4 | 77.3 | 62.3 | 0.012 | 3.12 | 2.65 | 0 |
| COMPARISON EXAMPLE 5 | bal. | 60 | 0.5 | 0.03 | 0 | 0 | 148.7 | 63.9 | 54.3 | 0.011 | 3.22 | 2.46 | 0 |
| COMPARISON EXAMPLE 6 | bal. | 40 | 0.2 | 0.03 | 0 | 0 | 173.8 | 75.9 | 77.6 | 0.032 | 2.98 | 2.21 | 19 |
| COMPARISON EXAMPLE 7 | bal. | 40 | 1.1 | 0 | 0 | 0 | 207.9 | 77.1 | 61.4 | 0.010 | 2.88 | 2.48 | 0 |
| COMPARISON EXAMPLE 8 | bal. | 40 | 1.1 | 0.03 | 0 | 0 | 233.7 | 77.3 | 59.3 | 0.010 | 3.26 | 2.58 | 0 |
| COMPARISON EXAMPLE 9 | bal. | 40 | 0.5 | 0.004 | 0 | 0 | 173.2 | 76.1 | 79.3 | 0.013 | 2.62 | 2.62 | 0 |
| COMPARISON EXAMPLE 10 | bal. | 40 | 0.5 | 0.07 | 0 | 0 | 174.3 | 75.3 | 55.7 | 0.012 | 3.28 | 2.71 | 0 |

As shown in Table 1, in the embodiments 1 through 33, all of the embodiments indicated such a result that the melting points thereof were 185 degrees C or less; the tensile strengths thereof were 70 MPa or more; the elongations thereof were 65 % or more; the thicknesses of P-rich layers thereof were 0.014 µm; the shear strengths of the solder joints formed by using the Cu electrodes were 3.00N or more; the shear strengths of the solder joints formed by using the electroless Ni/Au electrodes were 2.60 N or more; and the plate exposure percentages thereof were all 0 %.

Examples 1 to 21 are comparative examples since they do not contain P and/or Ge.

On the other hand, the comparison example 1 which was Sn-58Bi solder alloy and did not contain Cu and Ni indicated that the thickness of P-rich layer was thick; the shear strengths in the Cu electrodes and the electroless Ni/Au electrodes severely deteriorated; and the plate exposure percentage was also high.

Both of the comparison example 2 which did not contain Ni and the comparison example 3 which did not contain Cu indicated that the thicknesses of P-rich layer were thick; and the shear strengths in the Cu electrodes and the electroless Ni/Au electrodes severely deteriorated. Particularly, the comparison example 3 which did not contain Cu indicated the high plate exposure percentage.

Since the comparison example 4 which contained less amount of Bi indicated the high melting point and less elongation, it was certified that any strain occurred in the substrate. The comparison example 5 which contained much amount of Bi indicated that the alloy was inferior in the tensile strength and the elongation thereof. Further, it indicated that the shear strength in the electroless Ni/Au electrode was inferior and the elongation of the solder alloy was inferior.

The comparison example 6 which contained less amount of Cu indicated that the shear strength in the electroless Ni/Au electrode was inferior, the thickness of P-rich layer was thick, and the plate exposure percentage was high. Both of the comparison example 7 which did not contain Ni and contained much amount of Cu and the comparison example 8 which contained much amount of Cu indicated that these alloys had high melting points and were inferior in the elongation and the shear strengths in the electroless Ni/Au electrode were inferior.

The comparison example 9 which contained less amount of Ni indicated that the shear strength in the Cu electrode was inferior. The comparison example 10 which contained much amount of Ni indicated that the alloy was severely inferior in the elongation thereof.

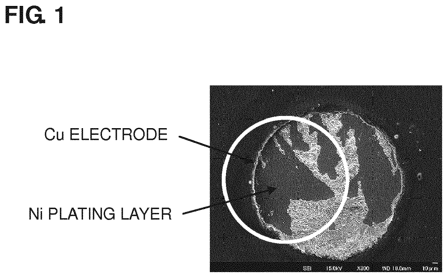

FIG. 1 is a SEM photograph showing a sheared surface of electrode after the electroless Ni/Au electrode is soldered using Sn-58Bi solder alloy and the solder joined portion is sheared and removed. In all of the comparison examples 1, 3, 5 and 6, Ni plating layer was exposed as shown in FIG. 1. It is conceivable that this is because P-rich layer grows and peeling occurs at an interface between the P-rich layer and the electroless Ni/Au plating layer.

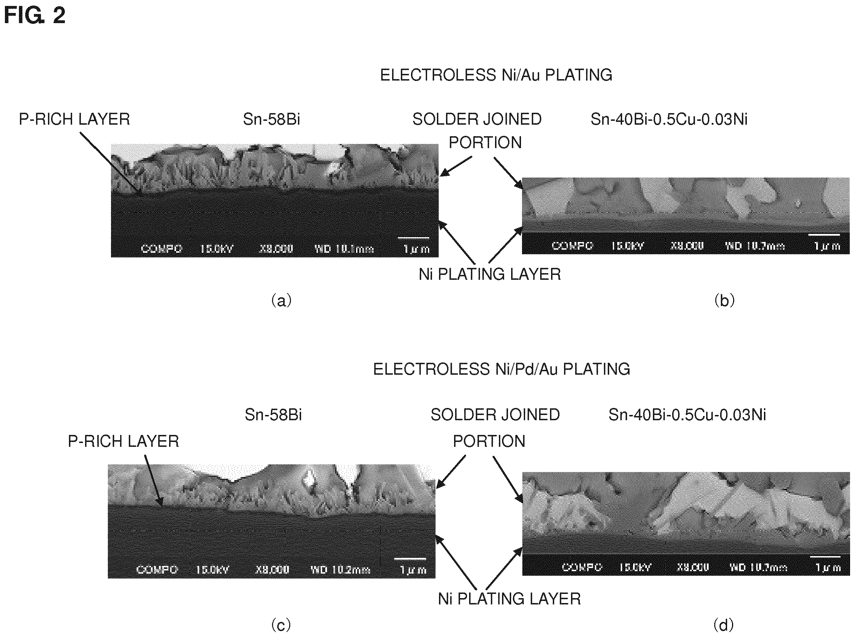

FIGS. 2(a) and 2(b) are sectional SEM photographs each showing a neighborhood of an interface between the solder joined portion and the electrode within a solder joint when the solder joint is formed by soldering the electroless Ni/Au electrode. FIGS. 2(c) and 2(d) are sectional SEM photographs each showing a neighborhood of an interface between the solder joined portion and the electrode within a solder joint when the solder joint is formed by soldering the Cu electrode on which electroless Ni/Pd/Au plating has been performed. It was clear from FIGS. 2(a) and 2(c) that since Sn-58Bi solder alloy (of the comparison example 1: the shear strength in the electroless Ni/Au electrode was of 2.01 N) did not contain Cu, P-rich layer grew. On the other hand, it was clear from FIGS. 2(b) and 2(d) that since Sn-40Bi-0.5Cu-0.03Ni solder ally according to this invention (of Embodiment 7: the shear strength in the electroless Ni/Au electrode was of 2.85 N) contained predetermined amounts of Cu and Ni, this suppresses the growth of P-rich layer, so that any P-rich layer could not be confirmed from these photographs. Thus, from FIGS. 2, it is understood that the suppression of the growth in P-rich layer enables the shear strength to be considerably improved.

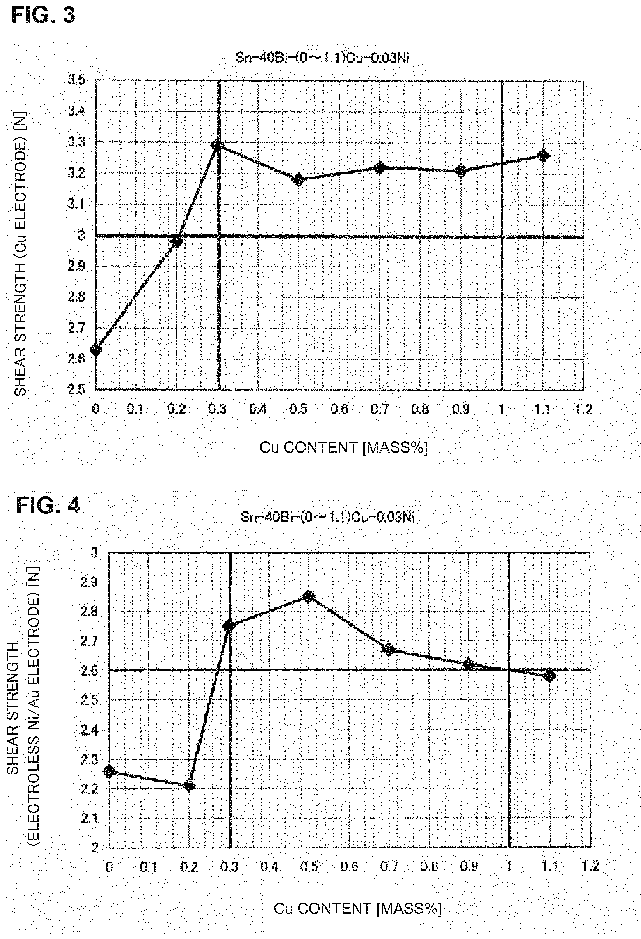

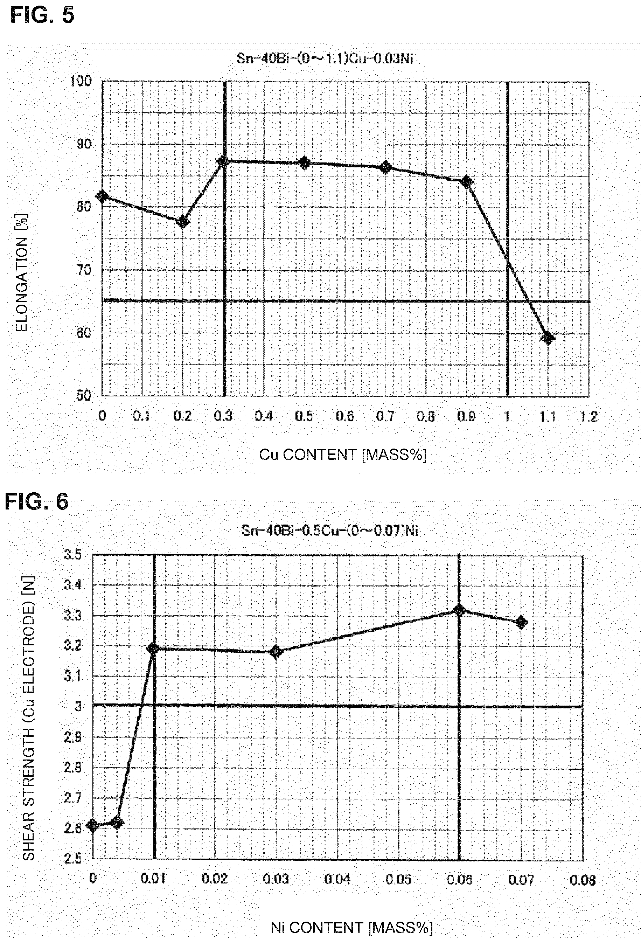

Based on the results of Table 1, the relationships between contents of Cu and Ni in the solder alloys and the Cu electrode, the electroless Ni/Au electrode and elongation are shown in FIGS. 3 through 8. In FIGS. 3 through 5, the results of the embodiments 6 through 9 and the comparison examples 3, 6 and 7 in which the solder alloys contain 40 % of Bi and 0.03 % of Ni have been used. In FIGS. 6 through 8, the results of the embodiments 7, 10 and 11 and the comparison examples 2, 8 and 9 in which the solder alloys contain 40 % of Bi and 0.5 % of Cu have been used. FIG. 3 is a graph showing a relationship between Cu content and shear strength (in the Cu electrode) in Sn-40Bi-(0-1.1)Cu-0.03Ni solder alloy. FIG.4 is a graph showing a relationship between Cu content and shear strength (in the electroless Ni/Au electrode) in Sn-40Bi-(0-1.1)Cu-0.03Ni solder alloy. FIG. 5 is a graph showing a relationship between Cu content and elongation of the alloy in Sn-40Bi-(0-1.1)Cu-0.03Ni solder alloy. From FIGS. 3 through 5, it becomes clear that the range of Cu indicating that the shear strength of the Cu electrode is 3.0 N or more, the shear strength of the Ni electrode is 2.6 N or more and the elongation is 65 % or more is of 0.3 through 1.0 %.

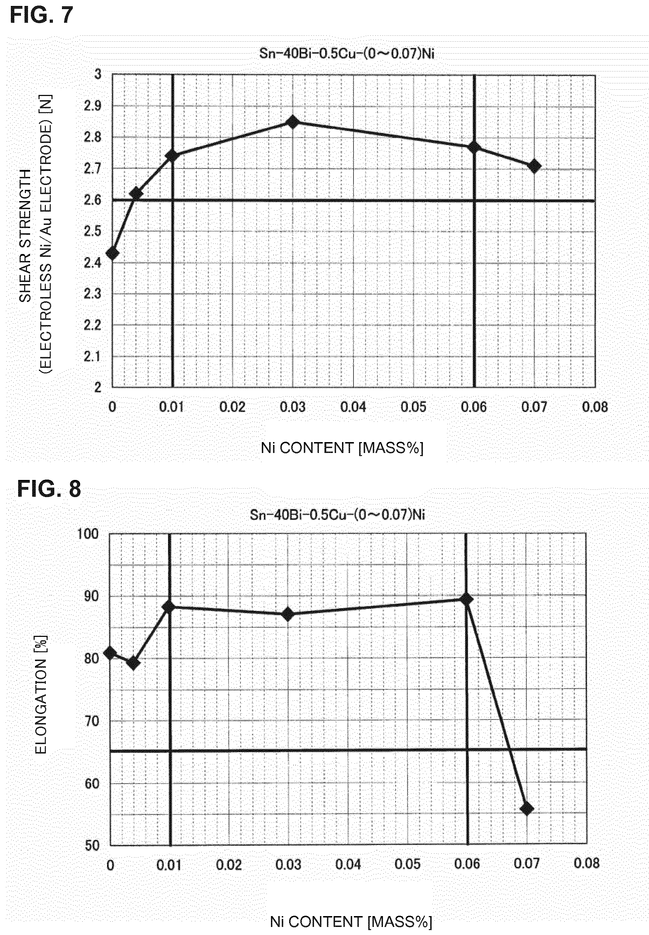

FIG. 6 is a graph showing a relationship between Cu content and shear strength (in the Cu electrode) in Sn-40Bi-0.5Cu-(0-0.07)Ni solder alloy. FIG. 7 is a graph showing a relationship between Cu content and shear strength (in the electroless Ni/Au electrode) in Sn-40Bi-0.5Cu-(0-0.07)Ni solder alloy. FIG. 8 is a graph showing a relationship between Cu content and elongation of the alloy in Sn-40Bi-0.5Cu-(0-0.07)Ni solder alloy. From FIGS. 6 through 8, it becomes clear that the range of Ni indicating that the shear strength of the Cu electrode is 3.0 N or more, the shear strength of the Ni electrode is 2.6 N or more and the elongation is 65 % or more is of 0.01 through 0.06 %.

## Claims

1. A lead-free solder alloy for joining a Cu electrode which contains an Ni plating layer, the solder alloy having an alloy composition which consists of 31 to 59 mass % of Bi, 0.3 to 1.0 mass % of Cu, 0.01 to 0.06 mass % of Ni, and at least one element selected from the group consisting of 0.001 to 0.07 mass % P and 0.001 to 0.03 mass % Ge, and a balance of Sn wherein the solder alloy has a melting point of 185 degrees C or less, a tensile strength of 70 MPa or more and elongation of 65 % or more.

2. The lead-free solder alloy according to Claim 1, consisting of 31 to 59 mass % of Bi, 0.3 to 1.0 mass % of Cu, 0.01 to 0.06 mass % of Ni, and at least one element selected from the group consisting of P and Ge in a total of 0.003 to 0.05 mass %, and a balance of Sn.

3. A solder joint formed on a Cu electrode having a Ni plating layer by using the lead-free solder alloy according to Claim 1 or 2.

4. The solder joint according to claim 3 further comprising a P-rich layer formed at an interface between the lead-free solder alloy and the Ni plating layer.

5. A substrate having a thickness of 5 mm or less and plural Cu electrodes each having Ni plating layer wherein each of the Cu electrodes includes a solder joint formed by using the lead-free solder alloy according to Claim 1 or 2.

6. The substrate according to claim 5 wherein the Ni plating layer contains P.

## Patentansprüche

1. Bleifreie Lötmittellegierung zum Verbinden einer Cu-Elektrode, die eine Ni-Plattierungsschicht enthält, wobei die Lötmittellegierung eine Legierungszusammensetzung aufweist, die aus 31 bis 59 Masse-% Bi, 0,3 bis 1,0 Masse-% Cu, 0,01 bis 0,06 Masse-% Ni und wenigstens einem Element ausgewählt aus der Gruppe bestehend aus 0,001 bis 0,07 Masse-% P und 0,001 bis 0,03 Masse-% Ge und dem Rest aus Sn besteht, wobei die Lötmittellegierung einen Schmelzpunkt von 185 Grad C oder weniger, eine Zugfestigkeit von 70 MPa oder mehr und eine Dehnung von 65 % oder mehr aufweist.

2. Bleifreie Lötmittellegierung gemäß Anspruch 1, bestehend aus 31 bis 59 Masse-% Bi, 0,3 bis 1,0 Masse-% Cu, 0,01 bis 0,06 Masse-% Ni und wenigstens einem Element ausgewählt aus der Gruppe bestehend aus P und Ge in einer Gesamtmenge von 0,003 bis 0,05 Masse-% und dem Rest aus Sn besteht.

3. Lötverbindung, die aus einer Cu-Elektrode mit einer Ni-Plattierungsschicht unter Verwendung der bleifreien Lötmittellegierung gemäß Anspruch 1 oder 2 gebildet ist.

4. Lötverbindunggemäß Anspruch 3, ferner umfassend eine P-reiche Schicht, die an einer Grenzfläche zwischen der bleifreien Lötmittellegierung und der Ni-Plattierungsschicht gebildet ist.

5. Substrat mit einer Dicke von 5 mm oder weniger und mehreren Cu-Elektroden, die jeweils eine Ni-Plattierungsschicht aufweisen, wobei jede der Cu-Elektroden eine Lötverbindung umfasst, die unter Verwendung der bleifreien Lötmittellegierung gemäß Anspruch 1 oder 2 gebildet ist.

6. Substrat gemäß Anspruch 5, wobei die Ni-Plattierungsschicht P enthält.

## Revendications

1. Alliage de brasage sans plomb destiné à assembler une électrode de Cu qui contient une couche de placage de Ni, l'alliage de brasage ayant une composition d'alliage qui est constituée de 31 à 59 % en masse de Bi, 0,3 à 1,0 % en masse de Cu, 0,01 à 0,06 % en masse de Ni, et au moins un élément choisi dans le groupe constitué par 0,001 à 0,07 % en masse de P et 0,001 à 0,03 % en masse de Ge, et pour le reste de Sn, l'alliage de brasage ayant un point de fusion de 185 degrés C ou moins, une résistance à la traction de 70 MPa ou plus et un allongement de 65 % ou plus.

2. Alliage de brasage sans plomb selon la revendication 1, constitué de 31 à 59 % en masse de Bi, 0,3 à 1,0 % en masse de Cu, 0,01 à 0,06 % en masse de Ni, et au moins un élément choisi dans le groupe constitué par P et Ge pour un total de 0,003 à 0,05 % en masse, et pour le reste de Sn.

3. Joint de brasure formé sur une électrode de Cu ayant une couche de placage de Ni au moyen de l'alliage de brasage sans plomb selon la revendication 1 ou 2.

4. Joint de brasure selon la revendication 3 comprenant en outre une couche riche en P formée à une interface entre l'alliage de brasage sans plomb et la couche de placage de Ni.

5. Substrat ayant une épaisseur de 5 mm au moins et plusieurs électrodes de Cu ayant chacune une couche de placage de Ni, chacune des électrodes de Cu comportant un joint de brasure formé au moyen de l'alliage de brasage sans plomb selon la revendication 1 ou 2.

6. Substrat selon la revendication 5 dans lequel la couche de placage de Ni contient du P.
